(19) Europäisches Patentamt
European Patent Office
Office européen des brevets

(11) **EP 4 306 974 A1**

(12) **EUROPEAN PATENT APPLICATION**

(43) Date of publication:
**17.01.2024 Bulletin 2024/03**

(51) International Patent Classification (IPC):
***G01R 31/12*** *(2020.01)*

(21) Application number: **22185243.7**

(52) Cooperative Patent Classification (CPC):
**G01R 31/1272**

(22) Date of filing: **15.07.2022**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **VITO NV**
**2400 Mol (BE)**

(72) Inventors:
• **VAN TICHELEN, Paul**
  **B-2400 Mol (BE)**
• **WANG, Da**
  **B-2400 Mol (BE)**

(74) Representative: **Nederlandsch Octrooibureau**
**P.O. Box 29720**
**2502 LS The Hague (NL)**

(54) **METHOD AND SYSTEM FOR DETECTING ARCS IN A DC GRID, AND METHOD OF CHECKING COMPLIANCE OF ELECTRICAL DEVICES FOR CONNECTION TO SAID DC GRID**

(57) A method and system for detecting an occurrence of an arc in a DC grid, wherein electrical devices are connectable to the DC grid, wherein the method includes providing at least one detector unit in the DC grid, the detector unit being configured to measure arc noise voltage superimposed on a DC grid voltage without a direct measurement of the current flowing through the arc itself, wherein the arc noise voltage is associated to the occurrence of an arc in the DC grid, and wherein a minimum impedance range in a predefined frequency range is ensured for each of the electrical devices connected to the DC grid.

FIG 1

**Description**

FIELD OF THE INVENTION

The invention relates to monitoring a direct current (DC) grid. The invention also relates to a method and system for detecting an occurrence of an arc in a direct current (DC) grid to which electrical devices are connectable.

BACKGROUND TO THE INVENTION

A DC power system can be used in renewable energy generation systems, DC load systems, electrical vehicles, etc. Such DC power systems can provide for higher energy efficiency, better power quality and more flexible operation modes. The DC power system or so-called DC grids may comprise one or more DC voltage sources which supply a DC voltage to DC loads through diverse DC connections. For example, a plurality of solar panels and/or batteries can be connected to power electronics loads. In some cases, a DC source can also act as a DC load, such as a battery cell/module when it is being charged.

The occurrence of DC arcs in DC systems (e.g. photovoltaic, battery storage, EV charging, etc.) can result in a serious safety hazard. A DC arc may be caused by loose terminals/contacts, aging insulations, electric components or devices, mechanic damages, poor installations, or even animal bites. Depending on the location of the arc in the DC power system, DC arcs can be series arcs, line-to-line parallel arcs or arcs to ground.

An arc can be a luminous discharge of electricity across an insulating medium, usually accompanied by the partial volatilization of electrodes. A large amount of heat can be dissipated into the surrounding during a relatively short period of time, which can carbonize or even ignite the insulation and other combustible materials in its surroundings. Therefore, arc detection is a key protection measure for DC micro grids.

However, different from alternative current (AC) arc currents, no zero-crossing point exists in DC arc currents. Conventional zero crossing protections may not be usable. Besides, DC arc could be considered as a variable resistor embedded in the circuit, so the circuit current will reduce during a serial arc. The overcurrent protections typically employed in the art may not be able to adequately detect arcs in DC grids. It is desired to provide for an adequate arc detection method/system which can be used to suppress the arcing before some incident happens.

On the other hand, power electronics are widely used in DC micro grids. Power electronics use switch-mode converters and therefore emit noise or so-called switching harmonics to DC power systems. Switching harmonics may increase electricity losses, overheat devices, or cause components failures/malfunctions due to interference with control logic. For example also, excessive harmonics should be filtered to ensure the reliability of arc detection.

The existence of switching harmonics challenges the efficiency and reliability of current arc detection methods. The existing arc detection methods can be classified into three categories:

- Physical characteristics based methods, like sound, light based arc detections. But the involved sensors should be installed at proper locations, normally near possible arc fault locations. This limits the application of such methods to some small spaces, like closed cabinets.
- Time domain signals based methods. This kind of methods measure the magnitude, average or change of ratio of particular current or voltage to judge if one arc occurs.
- Frequency domain signals based methods, like wavelet and Fast Fourier transform (FFT). Arc behaviors are uncertain, depending on temperature, humidity, contactor corrosion, load status, and so on. This generates a large amount of conducted electrical noise during arc burning, typically over a wide bandwidth (e.g. 2 kHz - 150 kHz), see for example in publication "Low Frequency Conducted Emissions Caused by Series Arc Faults ", C. Rose, D. W. P. Thomas, C. Smartt, P Meng, in Proc. 2019 International Symposium on Electromagnetic Compatibility-EMC EUROPE, Barcelona, Spain, 2-6 Sept. 2019.

However, the time domain signals and the frequency domain signals are inevitably susceptible to harmonics/noise in DC micro grids. For instance, excessive noise existing in the same bandwidth for arc detection will cover the noise generated by arcing, which is challenging to distinguish both.

Publication EP3599693A1 describes the detection of the arc by an external signal injected by one transmitting device. A communication transformer is inserted serially into the PV circuit, which causes a large DC current to flow through the primary side coil. Publication US10291016B2 detects the arc by doing Fast Fourier Analysis (FFA) of the arc current signal measured at the output side of a photovoltaic array. This publication necessitates a current transformer for a particular PV application that measures the full current of the PV panels. In general, prior art for arc detection uses an arc current detector. However, this can become bulky because the current detector needs to be sized based on the maximum current of the grid.

There is a strong desire to ensure that DC arcs are detected properly with background noise, especially in complex DC grids with multiple loads and sources or multiple devices. It is needed to provide for a reliable arc detection method/system which could be easily applied to a wide variety of DC networks and in a cost-effective way. It is also beneficial when a single arc detector can detect the arc occurrence in a large microgrid wherever it is connected or located. It is sometimes also beneficial to have selective arc detection in complex DC grids, meaning that arc detection can be done in different segments of a grid so that the defected segment can be disconnected while keeping another segment operational. This way DC grids can be made more redundant and failure proof while having arc detection.

Also, some arcs occur between the voltage terminals of the DC grid and the protective earth. In order to have an improved fault-diagnostics a combination with an Insulation Monitoring Device (IMD) which detects insulation faults between the voltage conductors and earth in a DC grid can be beneficial. An example of IMD is disclosed in patent EP1265076.

SUMMARY OF THE INVENTION

It is an object of the invention to provide for a method and a system that obviates at least one of the above mentioned drawbacks.

Additionally or alternatively, it is an object of the invention to improve detection of arcs in a DC grid.

Additionally or alternatively, it is an object of the invention to provide for a method/system which can better ensure that DC arcs are detected adequately, even with background (electrical) noise.

Additionally or alternatively, it is an object of the invention to improve safety of operation of a DC grid.

Thereto, the invention provides for a method for detecting an occurrence of an arc in a DC grid, wherein electrical devices are connectable to the DC grid, wherein the method includes providing at least one detector unit in the DC grid, the detector unit being configured to measure arc noise voltage superimposed on a DC grid voltage without a direct measurement of the current flowing through the arc itself, wherein the arc noise voltage is associated to the occurrence of an arc in the DC grid, and wherein a minimum impedance range in a predefined frequency range is ensured for each of the electrical devices connected to the DC grid.

Advantageously, a method that does not rely on the arc current measurement but only on DC bus ripple voltage measurement and is able to work in a complex DC environment with multiple electrical loads and/or sources with an high degree of flexibility where the detection system is installed in the DC grid. As there is no need to measure the current that flows to the arc, there is also no need to use a current transformer and/or a shunt.

It was found that arc detection can also be done reliably based on measuring the arc noise voltage which is superimposed on the DC grid voltage on the condition that all electrical devices connected in a DC microgrid have some minimum impedance in the frequency range of the arc noise. Advantageously, there is no need for a direct measurement of the current that flows through the arc itself. The minimum impedance of the electrical devices has two purposes. First, it warrants that the current ripple of the arc noise is converted to the voltage level which is easier to measure. Secondly, the impedance of each load should be high enough relatively to the line impedance of the electrical network which is typically mostly inductive and typically 5 to 50 $\mu$H in order not to attenuate the arc voltage signal and allow easy detection everywhere in the DC grid, independent of the location of the detector.

As a consequence, this invention requires that the impedance of all electrical devices connected to the DC grid is above a predetermined minimum impedance or impedance threshold in the predefined frequency range. Compliance of electrical devices in the DC grid with the predetermined minimum impedance requirement can either be checked by means of a compliance measurement or alternatively by putting a default or predefined minimum series inductor with the electrical devices so that the impedance is anyway above the minimum threshold.

The method provides for an improved detection of arcs in the DC grid. The arc formation can be sensed in a reliable and robust way, significantly improving the operational safety of the DC grid. Advantageously, a coherent and relative cost-effective arc detection can be provided for DC grids with multiple loads and sources. The arc detection can be employed easily for large and/or complex DC grids. The resultant arc detector unit can be easily connected in parallel to the source and the load where an arc is assumed to occur.

For example, a typical line impedance according to standard CISPR 16 is 50 $\mu$H which equals an impedance at 30 kHz of j.$\omega$.L or j.2.pi.30kHz. 0.05 mH or 9.4 Ohm. Therefore, considering this and based on experiments, optionally, each electrical fitting unit is configured to set a minimum impedance range larger than 0.5 Ohm, more preferably larger than 2 Ohm, in a frequency range of 40 kHz to 300 kHz, preferably in a frequency range of 40 to 100 kHz. The minimum impedance range may in general also be chosen based on the power source(s) and the cables of the DC grid depending on the application. In general, the higher the impedance of the loads the better arc detection will work in this new concept, therefore it is also referred to as a minimum impedance requirement or threshold.

Optionally, the minimum impedance range is imposed for all electrical devices to be connected to the DC grid.

Hence, each device connected to the DC grid has to satisfy the minimum impedance range. In this way, the arc detection can be significantly improved, and the safety of operation of the DC grid can be enhanced.

Optionally, a minimum impedance compliance of the electrical devices to be connected to the DC grid is ensured by means of at least one of: determining compliance based on characteristics of the devices and/or by performing a compliance measurement; or connecting the electrical devices to the DC grid via an electrical fitting unit configured to guarantee the minimum impedance range in the predefined frequency range for said electrical devices.

The compliance may be guaranteed after reconfiguration or without any changes of the electrical device circuitry depending on the compliance measurement results. In some examples, a device to be connected to the DC grid may be checked for compliance prior to actually connecting the electrical device to the DC grid. In some cases, the device may be reconfigured and/or another unit may be employed in order to comply with the minimum impedance requirement.

For compliance in some cases the electrical fitting unit is added in between the grid connection and electrical devices connected to the DC grid(s). The electrical fitting unit may for example be a minimum series inductor. However, various other devices may be used suitable for providing the minimum impedance. The electrical devices in DC grid(s) can be anything such as electrical loads (e.g. lamps, motors, etc.) and sources (e.g. PV panels, battery, etc.). However, it will be appreciated, that in some cases, no such electrical fitting unit may be needed, for example, due to a priori presumption of compliance, such as for example for simple resistive loads with resistance values above the minimum impedance.

In principle, a higher impedance can be beneficial for the arc detection. However, on the other hand the electrical fitting unit may become too bulky, so the selection of the minimum threshold is a balancing act and a compromise between better arc detection and size of the electrical fitting unit. In some advantageous examples, the minimum impedance threshold can be in between 0.5 to 50 Ohm in a frequency range of 40 to 300 kHz, preferably in a frequency range of 40 to 100 kHz.

Hence, some devices connected or to be connected to the DC grid may not require an electrical fitting unit according to the disclosure associated thereto. For example, for a LED device with relatively low power consumption (small wattage) its impedance may already be above a threshold. Such electrical devices may not require an electrical fitting unit associated thereto for guaranteeing a minimum impedance range. These electrical devices may be directly connected to the DC grid. Only the devices having too low impedances, i.e. the subset of electrical devices, may be connected to the DC grid indirectly by means of an electrical fitting unit therebetween. Another example that allows direct connection are particular cases of DC/DC switched converters when they have already incorporated a filter to suppress the switching noise that already provides compliance with the minimum impedance requirement, for example with inductors large enough.

Optionally, the configuration of the electrical fitting unit associated to the electrical device of the subset of electrical devices connected or to be connected to the DC grid is done based on said electrical device. The configuration of the electrical fitting unit may be based on measurements providing an indication of the impedance of the electrical device to be connected to the DC grid. In this way, a minimum impedance can be guaranteed using the electrical fitting unit.

The electrical fitting unit may be a minimum impedance network/circuit added in series to an electrical device in order to comply with the minimum impedance requirements.

The electrical fitting unit may be a minimum impedance unit having various electrical components. For example, the electrical fitting unit may include an electrical circuit. Optionally, the electrical fitting unit is a low pass filter. For example, the electrical fitting unit may include at least one series inductor. For instance, a simple arrangement of a minimum impedance circuit is a series inductor, thus also a low pass filter that allows the supply current to pass to the electrical device. Of course, this can also be a band pass filter or more complex circuitry that allows to comply with the minimum impedance requirement. Consequently, due to Ohm's law one can comply with the minimum impedance requirement by putting in series an inductor which is large enough. For example, if the minimum requirement is 2 Ohm at 40 to 100 kHz then adding a series inductor of 10 $\mu$H would provide compliance as it has larger than j.2.pi.40kHz.0,01 mH or 2.51 Ohm.

The inductor in the electrical fitting unit may comprise at least one electrical coil element. In some examples, the electrical circuit of the electrical fitting unit includes two inductors, or one on the series with the positive supply terminal and another in series with the negative supply terminal of the electrical device connected to the DC grid.

In some examples, the electrical circuit of the electrical fitting unit has a first side and a second side opposite the first side, wherein the second side is connected to the electrical device to which the electrical fitting unit is associated, and wherein the first side is connected to one or more lines of the DC grid, and wherein the electrical circuit of the electrical fitting unit has an inductor at the first side that is directly connected to the one or more lines of the DC grid.

In some examples, the electrical circuit of the electrical fitting unit includes at least one capacitor and at least one inductor arranged to obtain a higher order filter.

The electrical fitting unit may be any filter device configured to ensure that a minimum impedance requirement is met for the device connected or to be connected to the DC grid. In some examples, the filter comprises two inductors arranged in a line. In some examples, the filter is a low pass filter with at least two inductors connected to each other. Various implementations of the electrical fitting unit are envisaged.

Optionally, a subset of electrical devices, which are not compliant with said predetermined minimum impedance requirement if directly connected to the DC grid, are connected to the DC grid via the electrical fitting unit associated thereto, wherein each electrical fitting unit is arranged in series with the respective electrical device to which it is associated, and wherein each electrical fitting unit is configured to set the minimum impedance range in the predefined frequency range such as to meet the minimum impedance requirement.

In some examples, it is prevented that electrical devices with a capacitor are directly connected to the DC grid. Connecting such electrical device directly to the DC grid may result in filtering out the arc voltage signal, preventing the voltage detector unit to detect signals generated by an arc formation. Such electrical devices may be connected to an electrical fitting unit configured to provide for a minimum impedance. For example, a filter comprising inductors may be employed as previously described.

Optionally, the low pass filter comprises a circuit with one or more inductors and capacitors configured to achieve higher order filtering. Advantageously, this can further enhance the arc detection.

Optionally, the arc detector unit is arranged such as to measure the voltage ripple between the two poles of the DC grid. Thus, there is no direct arc current measurement. The detector unit may be configured to perform voltage measurements without using any current transformer.

Optionally, the DC grid includes at least a first branch and a second branch, wherein electrical devices are connectable to each of the first and second branches, and wherein each branch includes at least one detector unit, and wherein a low pass filter is added in between the branches to support selective arc detection and in order to identify the affected branch.

The method can be employed for complex DC grids.

Optionally, the DC grid includes a branch separation unit configured to block arc noise from propagating from the first branch to the second branch, and/or vice versa.

The detector unit may be arranged in multiple branches. In some examples, the detector unit is arranged in each branch of the DC grid. In some examples, the power supply to each branch can be controlled. In this way, when an arc formation is detected in one branch, an operability in the other branch(es) of the DC grid can be maintained. Other parts of the DC grid may remain operational if the arc formation is detected only on one branch.

Hence, if it is detected where the arc is formed in the DC grid, the controller may disable only the part of the DC grid where the arc is detected. For this purpose, the electrical noise induced by the arc can be blocked for each branch. With other words, the arc noise in one particular branch is limited only to the particular branch and propagation of the electrical noise to other branches may be substantially prevented. In order to effectively isolate the branches in the DC grid such as to prevent electrical noise to propagate to other branches, a DC capacitor can be used in combination with additional branch separation units described hereafter. The capacitor can be arranged so as to avoid an inter-branch voltage ripple. This provides an easy way to prevent that signals related to arc formation goes from one branch to another branch, thereby allowing selectivity. Advantageously, a localized arc noise detection can be performed at least on a branch level.

Optionally, the branch separation unit comprises a capacitor.

Optionally, at least one interrupter unit is provided for each branch which is configured to disconnect and/or disable one or more parts of the DC grid, wherein the one or more parts are selected based on the detection of the occurrence of an arc in a DC grid by the at least one detector unit.

After detection there can be an action for suppressing the arc formation. In some examples, the detection may be used for interrupting the voltage supply in order to stop the arcing and prevent further escalation. Various types of interrupter units can be used, such as for example electromechanical interrupters configured to disconnect at least a part of the circuit (e.g. part of a photovoltaic cells) of the DC grid but it can also be solid state switches.

Optionally, the interrupter unit comprises at least one switch for disconnecting one or more parts of the DC grid.

Optionally, the interrupter unit is configured to selectively disconnect at least one of the first and second branches.

Optionally, a blocking capacitor is provided to filter out a DC voltage component and a band pass filter is provided to subsequently only allow the noise electrical signals in a predetermined frequency ranged associated to the occurrence of an arc in the DC grid pass towards the detector unit.

Optionally, the blocking capacitor is a bandpass filter comprising at least one capacitor.

Optionally, the electric devices are electrical load devices or electrical source devices.

Optionally, the DC grid is configured such that new devices can be added to the circuit, and/or wherein at least a subset of devices arranged in the circuit are electrically detachable.

Optionally, the detector unit is configured to further monitor insulation faults between the voltage terminals of the DC grid and a protective earth.

In addition to arc detection in the DC grid, the detector unit can be configured to perform insulation detection in order to provide protection against electrocution. Advantageously, by providing a single device for this purpose can result in improved diagnostics of the operation of DC grid. There are different types of arcs, and some arcs may be advantageously reflected in the combined measurement, further improving the reliability of the arc detection. For example, arcs going through the housing or its protective earth can be better detected. Additionally, a more simple and cost-effective design can be obtained.

This arc detection based on voltage measurements is a good complement to the Insulation Monitoring Device (IMD) according to EP1265076, it can be implemented in the same processor and also do all minimum three voltage measurements with the same analog to digital converter and voltage reference. Combined IMD and arc fault detection can provide better fault diagnostics because series arcs could be discriminated from arc faults over the protective earth.

Optionally, the detector unit to measure insulation faults is configured to measure: a DC bus voltage; a DC bus ripple voltage usable for arc noise detection, wherein a blocking capacitor is employed such as to filter out the DC voltage; a first electrical voltage (Vi') related to a first electrical network connected to the protective earth, such as a resistance voltage divider resistor network; and a second electrical voltage (Vi") related to a second electrical network connected to the protective earth, such as another resistance voltage divider network with a same higher voltage resistor as said first electrical network but a different lower voltage resistor.

Optionally, a switch is used in the detector unit to measure insulation faults connecting the first electrical network by putting said switch into a first state and connecting the second electrical network by putting said switch into a second state; and wherein the DC bus voltage, the first electrical voltage (Vi') and the second electrical voltage (Vi") are measured with respect to the same reference voltage, such as for example the negative voltage of the DC bus; and wherein the insulation fault resistance value is calculated based on the DC bus voltage, the first electrical voltage (Vi') and the second electrical voltage (Vi").

A grid code may define some constraints for electrical equipment. For example, the grid code may improve electromagnetic compatibility between multiple electrical devices, and at least partially prevent that electrical device interfere with the operation of other electrical devices. Advantageously, by associating electrical fitting units to electrical devices connected or to be connected to the DC grid, it can be prevented that the electrical devices would prevent the reliable arc detection by the detector unit.

According to an aspect, the invention provides for a method for monitoring arc faults in DC grids with multiple loads and a protective device which is based on the measurement of conducted emission, wherein a grid code is implemented that limits in part conducted voltage and/or current noise within the frequency band of 1 to 500 kHz for loads and/or sources used in the DC grid, wherein an arc detection device is arranged which is configured to measures electrical signal noise within the frequency band of 1 to 500 kHz, and wherein the measured electrical signals can be either current and/or voltage signals. This will avoid interference and false signals signal in arc detection.

Optionally, the loads and/or sources also have a minimum impedance requirement in the frequency band of 500 kHz to allow enough large noise to flow through the arc detector. A minimum impedance larger than 2 Ohm in the frequency range of 40 kHz to 300 kHz can be employed.

Optionally, the loads and/or sources have a minimum series inductance requirement.

Optionally, requirements for conducted emission depend on the frequency bandwidth and the type of load or source.

Optionally, two predetermined frequency bands are allocated for the arc detection and power line communication.

Optionally, an analog and/or digital filter is added to the measurement signal for the arc detection and tuned to the emission limits in such manner that certain parts in the frequency with relative high limits are filtered out.

Optionally, the filter for arc detection filters out the predetermined frequency bands.

Optionally, the circuit for arc detection is connected in parallel to the DC bus.

Optionally, the arc parallel detection circuit contains a coupling transformer in series with a capacitor. One side of the transformer is connected to the DC grid and the other side to the detector. Such a transformer can be added to provide galvanic isolation between the detector unit and the DC grid.

Optionally, the detector unit which is installed in a bipolar DC micro grid. In the bipolar grid, the neutral point or conductor is added. The positive polar and the negative polar are considered as two DC voltage sources.

In order to monitor the arc on the positive line and the negative line, the detector unit can be connected between the positive polar and the neutral point, also between the negative polar and the neutral point, in parallel on the source side.

In each arc detection branch in a bipolar DC micro grid, one blocking capacitor can be used to prevent the DC current flowing through the detector unit. Consequently, one detector unit can detect arc faults in both the positive line, negative line and neutral line. Optionally, also for a bipolar DC grid, a coupling transformer could be used in the arc detector to provide galvanic isolation between the detector unit and the grid. Optionally, also for a bipolar DC grid, an analog and/or digital filter is added to the measurement signal for the arc detection and tuned to the emission limits in such manner that certain parts in the frequency with relative high limits are filtered out.

According to an aspect, the invention provides for a system for detecting an occurrence of an arc in a DC grid with one or more connectable electrical devices, wherein the system includes at least one detector unit connectable to the DC grid, the detector unit being configured to measure arc noise voltage superimposed on a DC grid voltage without a direct measurement of the current flowing through the arc itself, wherein the arc noise voltage is associated to the occurrence of an arc in the DC grid, and wherein the system is configured to ensure a minimum impedance range in a predefined frequency range for each of the electrical devices connected to the DC grid.

Advantageously, the system provides for a reliable and robust arc detection for adaptive DC grids. The design of the DC grid may be flexible (non-fixed design), wherein electrical devices can be added/removed without requiring changes to the detector unit. This provides for a cost-effective and universally applicable arc detection method for DC grids, easy to implement in existing DC grids.

The arc detection can be still reliable guaranteed, even if the number of electrical devices and/or the configuration of electrical devices in the DC grid is changed. For example, the DC grid can be dynamically scaled up or scaled down with connectable electrical devices. New devices to be connected to the DC grid may first be subjected to a compliance test in order to guarantee a minimum impedance. If needed, for example if the impedance is too low for the electrical device to be connected, then an electrical fitting unit may be provided for that device. The electrical fitting unit is configured such that the minimum impedance requirement can be guaranteed.

Advantageously, a cheap detector design can be obtained. In some examples, the detector unit is configured to sample the voltage, and includes a microcontroller configured to calculate a (frequency) spectrum. Advantageously, as a voltage signal is processed for identifying the presence of a signal component associated to the formation of an arc somewhere in the DC grid, it is not necessary to employ a current transformer. Such a current transformer should be dimensioned in a DC grid where it is unknown what the load is since various loads can be removed and/or added. Hence, using a current detector may require a redesigning or reconfiguration of the transformer if other loads are added/removed. Therefore, monitoring the voltage provides for significant advantages. Advantageously, according to the method/system of the disclosure, detection of the arc can be performed using voltage sampling measurements, wherein electrical devices connected to the DC grid comply with a minimum impedance requirement. Electrical devices that would not comply (e.g. by performing a compliance measurement) can be provided with an electrical fitting unit arranged between the electrical device and a line of the DC grid in order to guarantee a predetermined minimum impedance requirement. For example, such electrical devices may be provided with a low pass filter. Alternatively, electrical devices that would not comply, can be reconfigured to satisfy with the minimum impedance requirement when their electrical circuitry is known and allows for this reconfiguration,

Optionally, the compliance measurement includes determining an indication of the impedance by: superimposing a test signal on the voltage of the DC grid; wiring an impedance measurement bridge circuit in series to the electrical device to be tested; measuring a resulting amplitude voltage of the impedance measurement bridge circuit; and comparing the resulting amplitude voltage with a reference voltage curve that corresponds to the minimum impedance.

Optionally, the reference voltage curve corresponds to the voltage measured at the minimum impedance.

This compliance method can be used for example for the identification of electrical devices that need an electrical fitting unit or reconfiguration of their electrical circuit to comply with the minimum impedance requirement threshold.

According to an aspect, the invention provides for a method of determining compliance of an electrical device to be connected to a DC grid, wherein an indication of impedance for the electrical device is determined in order to check whether the electrical device meets a predetermined minimum impedance range, wherein the method includes: superimposing a test signal on the voltage of the DC grid; wiring an impedance measurement bridge circuit to the electrical device to be tested; measuring a resulting amplitude voltage of the impedance measurement bridge circuit; and comparing the resulting amplitude voltage with a reference voltage curve that corresponds to the to a minimum impedance.

A test-setup may be employed for verifying minimum impedance compliance requirements. For the identification of electrical devices that need an electrical fitting unit (and/or reconfiguring) to comply with the minimum impedance requirement threshold a compliance test can simply be done in a predetermined frequency range.

For example, an AC signal (e.g. 1 V), may be superimposed on a DC signal and the frequency may be changed in a range of 40 kHz to 300 kHz. The employed AC signal may mimic an arc signal. The output voltage $V_{ac\_load}$ is taken as an indicator to represent the load impedance. In particular, $V_{ac\_load}$ is a fraction of a well-defined input voltage, $V_{ac\_test}$, which comes from a signal generator. According to Kirchhoff laws, it is calculated as follows:

$$V_{ac\_load} = V_{ac\_test} \times Z_L/(Z_L + Z_{Ll}) \tag{1}$$

Where $Z_L$ denotes load impedance; $Z_{Ll}$ is the line impedance.

In a DC grid, the larger $Z_L$ is, the larger $V_{ac\_load}$ is. So, the load impedance is estimated by comparing $V_{ac\_load}$ with the reference voltage curve corresponding to the impedance threshold. If $V_{ac\_load}$ is larger than the reference voltage, it is considered that the device impedance is larger than the impedance threshold.

According to an aspect, the invention provides for a DC grid comprising a system according to the disclosure. A bandpass filter may be used to only let voltage noise in predefined frequency ranges (cf. bandwidth) pass. It is expected that an arc formation generates signals with frequency components within said predefined frequency range.

Furthermore, the transformer of such a current detector may have to be sized based on the arrangement/configuration of the grid. By employing a voltage detector unit and guaranteeing a minimum impedance for the electrical devices connected or to be connected to the DC grid, by arranging the electrical fitting units, a reliable discrimination between the detection of a real arc formation and other signals which are detected in the electrical circuit can be performed.

Advantageously, multiple identical voltage arc detector unit can be used in the DC grid, without requiring adapting the detector unit based on the configuration of the DC grid. Furthermore, the detector unit may remain operational even if the DC grid configuration is changed.

According to an aspect, the invention provides for a method and system for improving power line communication in a DC grid, wherein electrical devices are connectable to the DC grid, wherein the method includes providing at least one powerline communication unit in the DC grid, the powerline communication unit being configured to enable communication via DC grid voltage, wherein a minimum impedance range in a predefined frequency range is ensured for each of the electrical devices connected to the DC grid. Similar to the arc detection, the minimum impedance compliance provides for improved powerline communication in the DC grid.

It will be appreciated that any of the aspects, features and options described in view of the methods apply equally to the systems and the described devices and DC grid. It will also be clear that any one or more of the above aspects, features and options can be combined.

## BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:

Fig. 1 shows a schematic diagram of an embodiment of a system;
Fig. 2 shows a schematic diagram of an embodiment of a system;
Fig. 3 shows a schematic diagram of an embodiment of a system;
Fig. 4 shows a schematic diagram of an embodiment of a graph;
Fig. 5 shows a schematic diagram of an embodiment of a system;
Fig. 6 shows a schematic diagram of an embodiment of a system; and
Fig. 7 shows a schematic diagram of an embodiment of a test set-up;
Fig. 8 shows a schematic diagram of a method;
Fig. 9 shows a schematic diagram of an embodiment of a system;
Fig. 10 shows a schematic diagram of an embodiment of a system; and

## DETAILED DESCRIPTION

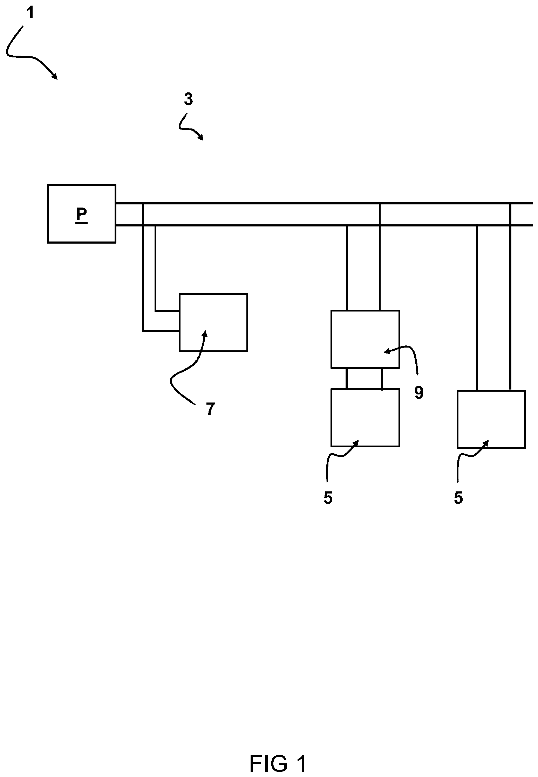

Fig. 1 shows a schematic diagram of an embodiment of a system 1 configured to detect an occurrence of an arc in a DC grid 3 with a DC power source P and connectable electrical devices 5. In this example, only two electrical devices 5 are shown, however, more electrical devices can be connected. The system 1 includes at least one detector unit 7 connectable to the DC grid 3. The detector unit 7 is configured to measure arc noise voltage superimposed on a DC grid voltage without a direct measurement of the current flowing through the arc itself. The arc noise voltage is associated to the occurrence of an arc in the DC grid 3. A minimum impedance range in a predefined frequency range is ensured for each of the electrical devices and the power source P connected to the DC grid. In this embodiment, the power source P is a particular kind of electrical device 5 which is essential to provide DC voltage to the grid. In principle various power sources could be connected in parallel in a DC grid. The detector unit 7 does not need to be installed close to the power source P but can also be installed on various locations in the grid, for example close to an electrical unit 5.

The detector unit 7 is configured to perform measurements of one or more electric signals such as to detect arc noise in said one or more signals. In some examples, a subset of electrical devices 5 may be connected to the DC grid via an electrical fitting unit 9 associated thereto. Each electrical fitting unit 9 may be arranged in series with the respective electrical device 5 to which it is associated. Furthermore, each electrical fitting unit 9 may be configured to set a preselected impedance range such as to ensure a minimum impedance. However, some electrical devices 5 may already comply with the minimum impedance. This can for example be determined by performing a test measurement. For such compliant electrical devices 5, no electrical fitting units 9 may be provided.

In some advantageous examples, arc noise voltage is measured instead of arc noise electrical current and/or DC current. The electrical fitting unit may enable transforming the arc noise current signal into an arc noise voltage signal which can be picked up by the detector unit. The electrical fitting unit can be seen as a minimum impedance device. If there is an arc, the induced arc noise will propagate through the DC grid. If one of the electrical devices has an impedance smaller than a threshold impedance, the arc current can flow through the electrical device and will not flow through the lines connected to the detector unit. By setting a minimum impedance for each electrical device connected or to be connected to the DC grid, it can be ensured that arc noise can always reach the detector unit. The electrical fitting units can be configured to increase the impedance to a value larger than a minimum value.

The system can enable a reliable arc failure detection (e.g. arc noise in a frequency range 10 to 200 kHz) and reduce the electromagnetic interference in a DC grid. A reliable arc detection can be obtained even for complex (adaptive) DC grids. The electrical fitting units associated to the subset of electrical devices can effectively avoid attenuation of the arc (voltage) signal in the DC grid. The electrical fitting units provide for a minimum impedance for the DC voltage sources or the loads. In some examples, this is implemented by means of a series inductors (>10 μH) per source or load (cf. subset of electrical devices).

In some examples, the detector unit 7 is configured to monitor the voltage noise. There is no need to measure the full arc current itself because it is measured through the voltage noise created by the inductors of the electrical fitting units. Advantageously, the voltage arc detector 7 may not require a large current transformer to measure the arc current. In principle one (unipolar DC) or two detector units (bipolar DC) are sufficient to detect the arc even in a complex topology. In some examples, the measurement circuit can be combined with power line modems.

A test system may be configured to check whether the impedance of an electrical device to be connected to the DC grid meets the minimum impedance requirement in the predetermined frequency range, preferably above 40 kHz. Based on the results of the compliance test, a corresponding electrical fitting unit may be selectively configured to increase the impedance to a value above a threshold minimum value, such that voltage signals induced by an arc formation can be effectively picked up by the detector unit.

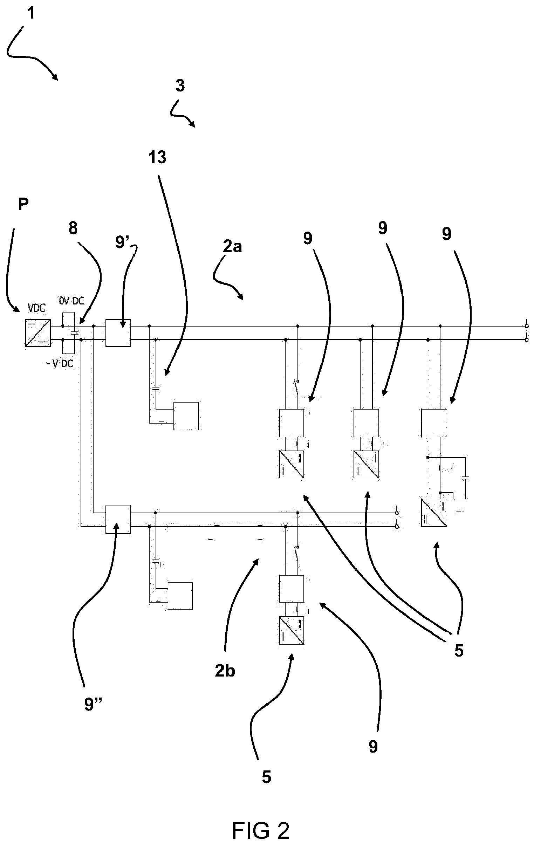

Fig. 2 shows a schematic diagram of an embodiment of a system 1 comprising a DC power source P. The DC grid 3 has two branches, namely a first branch 2a, and a second branch 2b. Multiple electrical fitting units 9 are arranged in order to ensure a minimum impedance. The detector unit 7 can detect an arc in the DC grid, since the DC grid has always a minimum impedance in between every connected load or source by ensuring a minimum impedance range in a predefined frequency range for each of the electrical devices 5 connected to the DC grid. In some cases, for electrical devices 5 which are not compliant with the minimum impedance, the electrical devices 5 are reconfigured to make them compliant or an electrical fitting unit 9 is arranged to guarantee the minimum impedance when the relevant electrical device 5 is connected to the DC grid. The detector unit 7 may be configured to measure one or more values indicative of the arc noise voltage. In this example, a capacitor 13 is used for blocking the DC voltage, such that only the arc noise voltage can pass towards the detector unit.

The subset of electrical devices may include any load/source in the DC grid 3 which has an impedance below a certain threshold (e.g. >2 Ohm.j.2.phi.f) in the frequency range in a frequency range of 40 to 300 kHz, preferably in a frequency range of 40 to 100 kHz. For example, a small resistive LED device with low wattage can be connected directly, without the need of reconfiguration and/or providing the additional electrical fitting unit 9, because it has an impedance above the 2 Ohm threshold.

Advantageously, in this example, a capacitor 8 is provided which can enable selectivity, which means arc formations can be detected in one branch of the network without interference in the other branch. Optionally, each branch may be provided with an additional electrical fitting unit 9', 9".

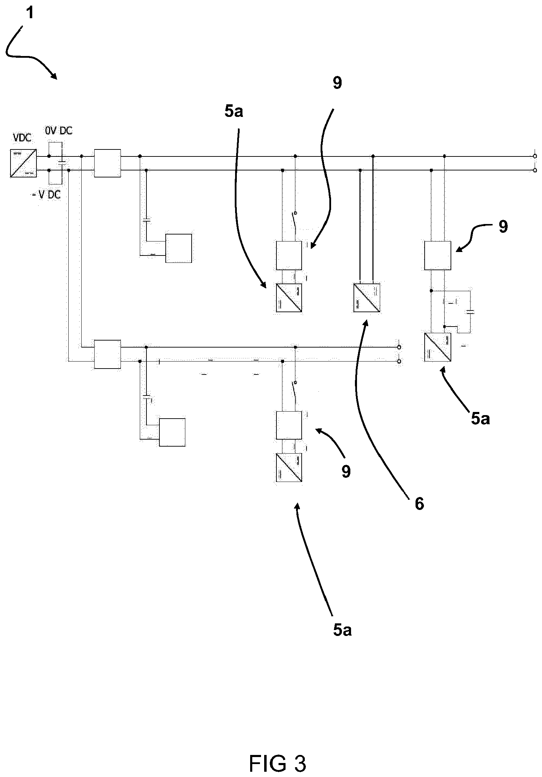

Fig. 3 shows a schematic diagram of an embodiment of a system 1. In this example, an electrical fitting unit 9 is associated to only a subset of electrical devices 5a for ensuring a minimum impedance. In this example, no electrical fitting unit is associated to electrical device 6. This electrical device 6 may not require a minimum impedance network, as it may already meet the minimum impedance requirement. The electrical device 6 may for instance be a LED device, a low power electrical device, etc.

If an arc is formed in the DC grid, an ultrasonic frequency signal may be effectively detectable by the detector unit whilst the effect of suppression of said generated signal due to the arrangement of one or more electrical devices in the DC grid can be effectively prevented by ensuring the minimum impedance requirement. If a device to be connected does not comply with the minimum impedance requirement, the device may be reconfigured prior to connection to the DC grid, and/or one or more electrical fitting units (connected to the non-complying electrical device) may be employed for guaranteeing said minimum impedance requirement.

The system is configured to have a minimum impedance requirement for each electrical device (e.g. electrical load or voltage source) connected to the DC grid. It can be first determined, for example by performing a compliance measurement, whether the electrical devices (e.g. photovoltaic panel, convertor, load, battery module, etc.) to be connected to the DC grid meet a predetermined minimum impedance requirement. Those electrical devices failing to meet such minimum impedance requirement may be provided with the electrical fitting unit, for example a series inductors, at their input or output depending on whether the relevant electrical device is a source or a load. The detector unit may be configured to measure a voltage signal providing for a cost-effective and compact design.

Additionally, the arrangement of the electrical fitting units can enable an adequate communication of signal over the wires of the DC grid, preventing that communication signals being suppressed by connected devices.

Optionally, each electrical device of the subset of electrical devices (not complying with the minimum impedance requirement if directly connected to the DC grid) is connected to the DC grid via a respective electrical fitting unit. In some examples, each of said subset of electrical devices can be indirectly connected to the DC grid via a respective electrical fitting unit 9.

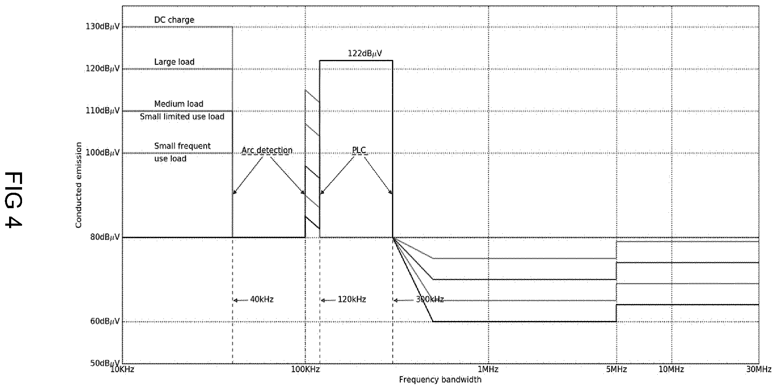

Fig. 4 shows a schematic diagram of an embodiment of a graph illustrating exemplary frequency spectrums and limits for conducted emissions of DC equipment, such as electrical devices including power sources that are part of a DC grid.

In order to better interface various electrical devices to DC grids and avoid the EMC interferences among them as well as the interferences with power line communication(PLC), switched power converters and arc detection, different conducted emission limits in particular frequency bands can be set for PLC, switched power converters and arc detection may be set. Specific frequency bands can be reserved for arc detection (40-100 kHz) and power line communication (120kHz-300kHz). In this example, the frequency band used for arc detection is from 40 kHz to 100 kHz. This will support arc detection while still enabling switched power electronic converters below 40 kHz without creating interference. Therefore, loads and sources, such as switched power converters in the DC grid, may have restrictive requirements in these frequency ranges. In some examples, between 100kHz and 120 kHz less restrictive requirements may be imposed which means for example less restrictive filtering requirements for third harmonics (3x37kHz) of switched power converters with switching frequency of 37 KHz. In some examples, power line communication can operate above 120 kHz up to 300 kHz and have therefore more relaxed emission limits in this frequency range.

Power line communication may also suffer from voltage signal attenuation when the grid impedance is low. For example, when a capacitor is placed in parallel on the DC grid it can filter out the power line modem signal. Therefore, a minimum line impedance for loads or generators is provided using the one or more electrical fitting units such as to facilitate power line communication in addition to arc detection. For example, the minimum impedance may be required to be larger than 2 Ohm in the frequency range of 40 kHz to 300 kHz. Hence this can be realized by adding an series input filter inductor of 10 $\mu$H or typically two times 4.7$\mu$H at a DC load side which equals j.2.$\pi$.40kHz.10$\mu$H or j2.5 Ohm. In brief this means that the minimum impedance requirements proposed for arc detection are also beneficial for power line communication if they apply in the frequency range of the power line modem.

Typically, in an electrical DC grid the impedance of an arc detection branch is related to the cable inductance and within the frequency range of 10 to 300 kHz this is 5 to 50 $\mu$H depending on the type and length of cables used

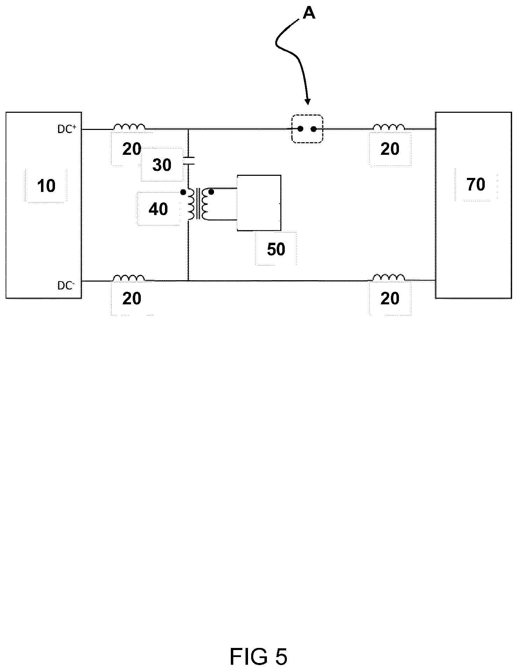

Fig. 5 shows a schematic diagram of an embodiment of a system comprising an arc detector unit arranged on a DC voltage source side. A possible arc phenomenon is indicated by A. The arc phenomenon may occur anywhere in the DC micro grid. A minimum impedance requirement may be imposed by means of inductors 20.

In this example, an arc detection circuit 30, 40, 50, is arranged in parallel to the electrical grid and is configured to detect the arc wherever it occurs, even when a more complex grid is connected. The arc detection does not require large current transformers that measure the current through the arc. By using a relative small optional transformer 40, it can easily be galvanically isolated from the electrical grid, meaning that the detection circuit can be safely be insulated from the DC grid voltage. The optional transformer 40 may be provided for providing additional safety insulation.

In this example, the DC voltage source 10 supplies the power to the load 70, both 10 and 70 are so called electrical devices of a DC grid. The DC voltage source could be PV, battery storage, etc. The arc detector 50 is connected to the DC voltage source in parallel through a DC voltage blocking capacitor 30 and a coupling transformer 40. The DC voltage blocking capacitor is configured to prevent the DC current flowing into the arc detector. As the benefit, no DC current flows through the coupling transformer and can thus be kept relative small. This is helpful to reduce the heat loss and the cost of transformer.

Only the noise signal can flow through the capacitor 30 and the coupling transformer 40. The arc noise can be first filtered by a band pass filter, which only allows the noise lying in the bandwidth 40 kHz - 100 kHz pass. Such a filter could be analogue or digital..

The filtered arc noise may be sent to a microprocessor for the arc detection, wherein the arc detection algorithm is developed. The time domain characteristics (like magnitude, change of ratio of voltage or current) or the frequency domain characteristics (like frequency spectrum) can be used for judging if one arc occurs. The detection algorithm compares the time domain / frequency domain characteristics before and after the arc to judge if one arc occurs in the downstream microgrids connecting to this DC voltage source.

When an arc occurs, as indicated by the symbol marked by A, due to the parallel connection between the arc detector and the DC voltage source, the arc noise could flow through the DC voltage source and the DC arc detector. If the impedance of DC voltage source during the bandwidth from 40 kHz to 100 kHz is similar or even less than the impedance of the arc detection branch, only a small part of arc noise (e.g. less than 50%) may flow through the arc detection branch, which is adverse to the arc detection. The measured arc noise by the detector may be covered by the background noise. In this case, it is difficult to distinguish both. So the impedance of DC source from 40 kHz to 100 kHz is required larger than the impedance of arc detection branch. If the impedance of DC source or an electrical device is too small, certain line impedance is installed in series between the DC voltage source and the arc detection branch. The minimum impedance of DC voltage source side is proposed as 2 Ohms. Depending on the practical application, this impedance can be increased. Typically, in an electrical DC grid the impedance of an arc detection branch is related to the cable inductance and 5 to 50 $\mu$H in the frequency range of arc detection. Therefore, imposing a minimum impedance to connected devices with sufficient large magnitude will facilitate arc detection by voltage measurement. If the minimum impedance threshold would be to small the arc voltage noise might attenuate and thus result in unreliable detection. Therefore also, minimum impedance thresholds (e.g. 2 Ohm) proposed have been found accordingly and checked experimentally.

The band pass filter and the microprocessor may be embedded in the PLC module if there exists one. In such a way, the arc detector and PLC share one coupling transformer. Since no DC current flows through the coupling transformer, the nominal current of coupling transform is small, decided by the arc noise. So, it is feasible to select the transformer with small coils. This is helpful to reduce the installation cost of arc detector. Besides, the arc detection algorithm can be programmed in the same processor used for PLC. If a digital filter is adopted, it can also be programmed in the PLC processor. This can further reduce the cost of arc detector.

Once an arc occurs, the conducted noise can flow through the dc-blocking capacitor and the coupling transformer. It can be measured on the secondary coil and further filtered by the band pass filter. The monitored arc noise is larger than the background noise. By comparing the arc noise and the background noise, the arc detector can judge if one arc occurs.

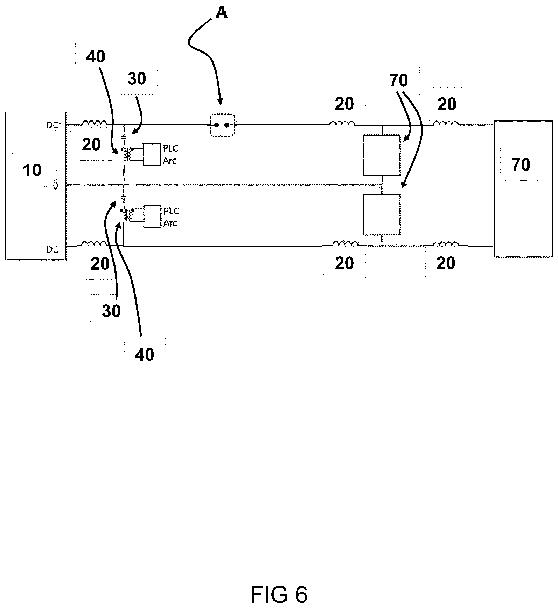

Fig. 6 shows a schematic diagram of an embodiment of a system comprising an arc detector in a bipolar DC micro grid.

The bipolar DC micro grid has a neutral line, which can result in improved supply flexibility and resilience than the unipolar DC micro grid. The source 10 is connected to loads 70. Transformers 40 provide galvanic isolation and additional safety for the detector units.

The arc detector unit is connected separately between the positive polar and the neutral point, as well as between the negative polar and the neutral point, in parallel on the DC voltage source side. In the bipolar model, two arc detector units can independently detect the arc on the positive cable and the negative cable. In case one polar is out of service, the arc detector connected to another polar still can work normally.

Again, to ensure the magnitude of arc noise flowing through the coupling transformer is enough large for the arc detection, a minimum impedance is required for the DC voltage source and the DC load. If the DC source / load impedance is too small, certain line impedance is connected in series between the arc detector and the voltage source / load. The required minimum impedance is selected as 2 Ohms for the positive / negative DC source and the load for this example. However, other values as indicated in the disclosure may be employed.

A band pass analogue / digital filter is installed to only allow the arc noise lying in the particular bandwidth enter into the arc detector processor. The arc detector judges the arc based on the differences in time domain / frequency domain characteristics of the arc.

The filters and arc detectors can be embedded into the PLCs existing on the DC source / load sides, in order to share the coupling transformers and reduce the arc detection cost.

The subset of electrical devices may each be associated to an electrical fitting unit configured to ensure a minimum impedance, such that arc (voltage) noise signals can effectively reach the (voltage) detector unit.

By providing the subset of electrical devices with the electrical fitting units (e.g. low pass filter), the formation of arcs in the DC grid can be better detected. The subset of electrical devices are not connected directly to one or more lines of the DC grid. Instead, an electrical fitting unit may be provided between the electrical devices of the subset of electrical devices and the one or more lines of the DC grid. The electrical fitting unit may be adapted to set a minimum impedance above a predetermined minimum impedance threshold.

Additionally, the method also enable more reliable power line communication (PLC) and avoid interference with the arc detection.

Additionally, a detector unit with two coupling capacitors (30) can be used that sums the arc noise of both poles and has only a single voltage measurement but this will obviously provide less information where the arc did occur.

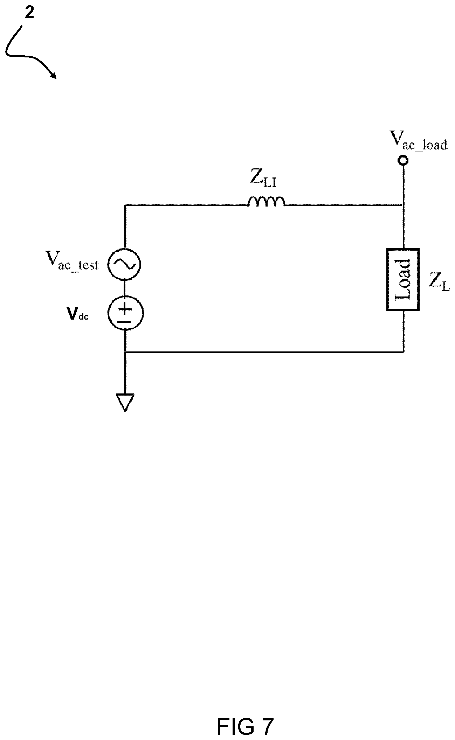

Fig. 7 shows a schematic diagram of an embodiment of a test set-up 2 for a compliance measurement. The compliance measurement can be carried out for the verification of compliance with the minimum impedance requirement in a predetermined frequency range. Taking a load as one example of an electrical device, the objective is to verify if the load impedance satisfies the minimum impedance requirement in a certain frequency range when it is powered on. Alternatively, the so-called load can also be a voltage source, a battery, etc. The principle of the proposed compliance measurement method is shown in the following figure and is based on a so-called impedance measurement bridge circuit. For the identification of electrical devices that need an electrical fitting unit to comply with the minimum impedance requirement threshold a compliance test can simply be done in a predetermined frequency range.

For the compliance measurement, a high frequency signal $V_{test}$ is superimposed on a DC voltage ($V_{dc}$), for example a sine wave frequency sweep signal from 40 kHz to 100 kHz. Obviously it can also be other type of signal as long as its frequency spectrum covers the frequency range of the minimum impedance requirement.

The impedance measurement bridge circuit concept uses a predefined series impedance ($Z_{L1}$) with the load ($Z_L$) under test.

As a consequence the voltage $V_{test\_load}$ is relative to the load impedance. In particular, $V_{test\_load}$ is a fraction of a well-defined input voltage, $V_{test}$, which comes from a signal generator. According to Kirchhoff laws, $V_{test\_load}$ is calculated as follows:

$$V_{test\_load} = V_{test} \text{ x } Z_L/(Z_L + Z_{LI}) \hspace{3cm} (1)$$

Where $Z_L$ denotes the load impedance; $Z_{LI}$ is the line impedance.

According to this formula, the larger $Z_L$ is, the larger $V_{test\_load}$ is and hence it can simply be used for compliance testing. Therefore, the load impedance threshold limit can be verified by comparing $V_{test\_load}$ with a said reference voltage curve corresponding to the impedance threshold. If $V_{test\_load}$ is larger than the reference voltage defined in the said reference voltage curve, the device impedance is larger than the impedance threshold and thus compliant. This has been verified by laboratory experiments. This method can work for example with a sine wave frequency whereby at each frequency the measurement voltage ($V_{test\_load}$) is compared to the said reference voltage curve. Alternatively the method can work faster if a $V_{test\_load}$ signal is measured in the time domain(t) and afterwards with a math calculation based on a Fourier Transform(FT) is converted to its amplitude in the frequency domain. In this case $V_{test}$ should be a signal that covers the frequency range of the minimum impedance requirement, for example an arbitrary signal with a frequency range of 40 to 100 kHz. The reference voltage curve for testing can easily be obtained by performing a calibration test relative to a resistor instead of the load ($Z_L$) with the value of the impedance threshold, for example a 2 Ohm calibration resistor for testing a 2 Ohm minimum impedance requirement of a load.

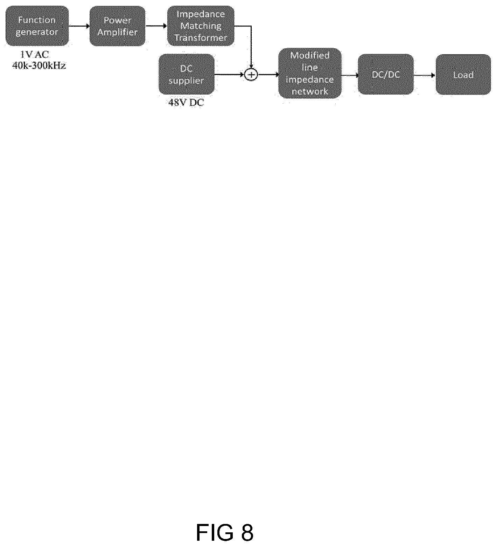

Fig. 8 shows a schematic diagram of a method of determining compliance of an electrical device to be connected to a DC grid. It can be important to get the credible voltage reference. A modified line impedance network can be employed which is configured to simulate the wiring in the DC grid. Loads with difference characteristics (resistive, inductive, etc.) and impedance values are tested to get the voltage reference.

The compliance measurement may include determining an indication of the impedance by: superimposing an AC signal on a DC network including a DC power source, wiring and the electrical device to be tested; measuring a resulting voltage; and comparing the resulting voltage with a reference voltage linked to the minimum impedance.

The test setup may generate an output voltage having a DC component (e.g. 1 V) and an AC component (e.g. in frequency range of 40 kHz to 300 kHz, or 40 kHz to 100 kHz). The generated output voltage may be applied on the device to be tested (cf. device to be connected to the DC grid), and then the impedance is calculated. It can be identified whether the device to be connected suppresses the applied generated signal (e.g. mimicking arc signal), which prevents the signal to reach the detector unit if the device would be directly connected to the DC grid.

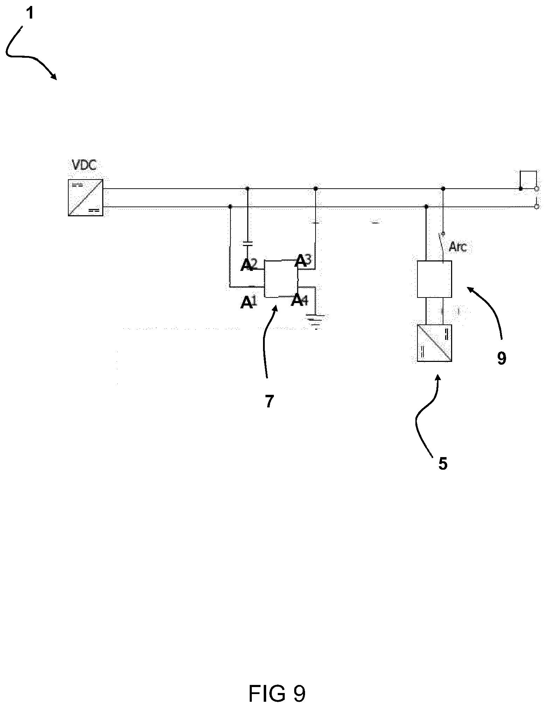

Fig. 9 shows a schematic diagram of an embodiment of a system 1. In this example, the detector unit is configured to further monitor insulation faults between the voltage terminals of the DC grid and a protective earth. The detector unit can be configured to measure a DC bus voltage; a DC bus ripple voltage usable for arc noise detection, wherein a blocking capacitor is employed such as to filter out the DC voltage; a first electrical voltage (Vi') related to a first electrical network connected to the protective earth, such as a resistance voltage divider resistor network; and a second electrical voltage (Vi") related to a second electrical network connected to the protective earth, such as another resistance voltage divider network with a same higher voltage resistor as said first electrical network but a different lower voltage resistor.

In some examples, a switch is used connecting the first electrical network by putting said switch into a first state and connecting the second electrical network by putting said switch into a second state; and the DC bus voltage, the first electrical voltage (Vi') and the second electrical voltage (Vi") are measured with respect to the same reference voltage, such as for example the negative voltage of the DC bus; and wherein the insulation fault resistance value is calculated based on the DC bus voltage, the first electrical voltage (Vi') and the second electrical voltage (Vi").

Advantageously, the detector unit may provide for a combined arc detection and insulation monitoring device in a cost-effective way. Connections A1 and A2 are connections for arc detection, and connections A1, A3 and A4 are connections for insulation monitoring.

The occurrence of DC arcs can coincide with insulation failures. Therefore, it is of interest to combine the arc detection method and/or circuitry with Insulation Monitoring Devices (IMD) for the purpose of better diagnostics and the cost of protection equipment. In particular floating DC grids use IMD as a safety measure for guaranteeing a proper electric insulation between the DC grid and the protective earth. IMD serves to provide protection against electrocution. Therefore, in addition to arc detection in the DC grid, the detector unit can be configured to perform IMD. Advantageously, a single device can result in improved diagnostics of the operation of a DC grid. There are different types of arcs, and some arcs may be advantageously reflected in the combined measurement. In particular those who connect to the protective earth would benefit the most, for example arcs going through the protective housing. Additionally, a more simple and cost-effective design can be obtained.

It has been found that the arc detection method contained in this invention based on voltage measurements is a good complement to the IMD, for example described in EP1265076 which is also based on voltage measurements that can be combined in the same device. Typically, the same processor can do all minimum three voltage measurements with the same analog to digital converter and relative to the same voltage reference such as the negative DC voltage of the grid.

Therefore the advantageous combination extends the arc detector unit which needs an arc voltage ripple measurements (A1 & A2) with the measurement of the DC bus voltage itself (A3 & A1) and at least one additional measurement channel (A4) to connect to the protective earth. This measurement channel (A4) is a high impedance connection to constitute itself as an insulation failure. Connection (A1) is a reference voltage connection for measurement channels (A2), (A3) and (A4).

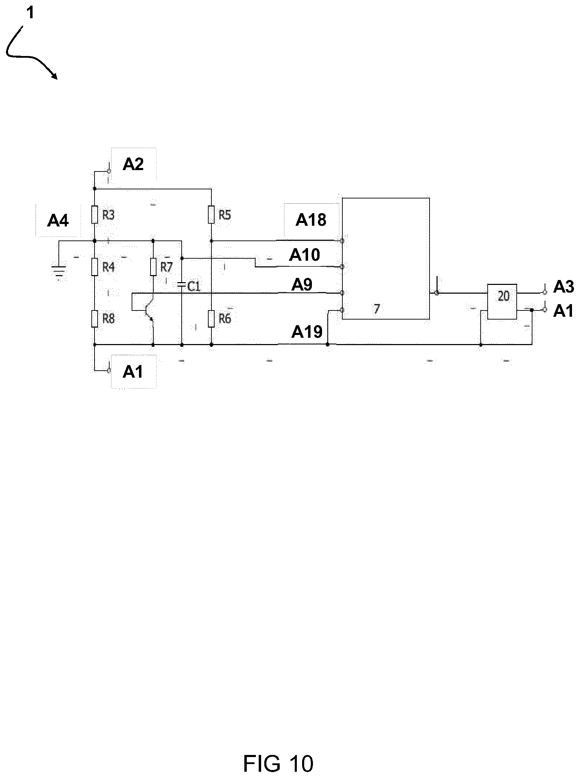

Fig. 10 shows a schematic diagram of an embodiment of a system 1. Similar to the embodiment shown in Fig. 9, the detector unit is configured to further monitor insulation faults between the voltage terminals of the DC grid and a protective earth. The detector unit can be employed for a cost-effective and easy way to perform arc detection monitoring and insulation monitoring, significantly improving the safety of the system 1.

For the calculation of the insulation fault measurement channel (A4) needs to measure first an electrical voltage (Vi') related to a said first electrical network connected to the protective earth and second another electrical voltage (Vi") related to a second electrical network connected to the protective earth. Therefore, a switch can be used connecting the said first electrical network by putting said switch into a first state and in another step connecting the said second electrical network by putting said switch into a second state. The DC bus voltage, Vi' and Vi" are measured with respect to the same reference voltage, such as for example the negative voltage of the DC bus, and afterwards the insulation fault resistance value is calculated based on the DC bus voltage, Vi' and Vi".

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The mere fact that certain measures are recited in mutually different claims does not indicate that a combination of these measures cannot be used to an advantage.

## Claims

1. A method for detecting an occurrence of an arc in a DC grid, wherein electrical devices are connectable to the DC grid, wherein the method includes providing at least one detector unit in the DC grid, the detector unit being configured to measure arc noise voltage superimposed on a DC grid voltage without a direct measurement of the current flowing through the arc itself, wherein the arc noise voltage is associated to the occurrence of an arc in the DC grid, and wherein a minimum impedance range in a predefined frequency range is ensured for each of the electrical devices connected to the DC grid.

2. The method according to claim 1, wherein the minimum impedance range is chosen to be larger than 0.5 Ohm, more preferably larger than 2 Ohm, in a frequency range of 40 kHz to 300 kHz, more preferably in a frequency range of 40 to 100 kHz.

3. The method according to claim 1 or 2, wherein the minimum impedance range is imposed for all electrical devices to be connected to the DC grid.

4. The method according to any one of the preceding claims, wherein a minimum impedance compliance of the electrical devices to be connected to the DC grid is ensured by means of at least one of:

   determining compliance based on characteristics of the devices and/or by performing a compliance measurement; or
   connecting the electrical devices to the DC grid via an electrical fitting unit configured to guarantee the minimum impedance range in the predefined frequency range for said electrical devices.

5. The method according to claim 4, wherein the compliance measurement includes determining an indication of the impedance by:

   superimposing a test signal on the voltage of the DC grid;
   wiring an impedance measurement bridge circuit in series to the electrical device to be tested;
   measuring a resulting amplitude voltage of the impedance measurement bridge circuit; and
   comparing the resulting amplitude voltage with a reference voltage curve that corresponds to the minimum impedance.

6. The method according to claim 4 or 5, wherein a subset of electrical devices, which are not compliant with said predetermined minimum impedance requirement if directly connected to the DC grid, are connected to the DC grid via the electrical fitting unit associated thereto, wherein each electrical fitting unit is arranged in series with the respective electrical device to which it is associated, and wherein each electrical fitting unit is configured to set the minimum impedance range in the predefined frequency range such as to meet the minimum impedance requirement.

7. The method according to any one of the preceding claims 4-6, wherein the electrical fitting unit is a low pass filter adapted to ensure compliance with the predetermined minimum impedance requirement.

8. The method according to claim 7, wherein the low pass filter comprises a circuit with one or more inductors and capacitors configured to achieve higher order filtering.

9. The method according to any one of the preceding claims, wherein the DC grid includes at least a first branch and a second branch, wherein electrical devices are connectable to each of the first and second branches, and wherein each branch includes at least one detector unit, and wherein a low pass filter is added in between the branches to support selective arc detection and in order to identify the affected branch.

10. The method according to any one of the preceding claims, wherein a blocking capacitor is provided to filter out a DC voltage component and a band pass filter is provided to subsequently only allow the noise electrical signals in a predetermined frequency ranged associated to the occurrence of an arc in the DC grid pass towards the detector unit.

11. The method according to any one of the preceding claims, wherein the detector unit is configured to further monitor insulation faults between the voltage terminals of the DC grid and a protective earth.

12. The method according to claim 11, wherein the detector unit is configured to measure:

   a DC bus voltage;
   a DC bus ripple voltage usable for arc noise detection, wherein a blocking capacitor is employed such as to filter out the DC voltage;
   a first electrical voltage ($V_i'$) related to a first electrical network connected to the protective earth, such as a resistance voltage divider resistor network; and
   a second electrical voltage ($V_i''$) related to a second electrical network connected to the protective earth, such as another resistance voltage divider network with a same higher voltage resistor as said first electrical network but a different lower voltage resistor.

13. The method according to claim 12, wherein a switch is used connecting the first electrical network by putting said switch into a first state and connecting the second electrical network by putting said switch into a second state; and wherein the DC bus voltage, the first electrical voltage ($V_i'$) and the second electrical voltage ($V_i''$) are measured

with respect to the same reference voltage, such as for example the negative voltage of the DC bus; and wherein the insulation fault resistance value is calculated based on the DC bus voltage, the first electrical voltage (Vi') and the second electrical voltage (Vi").

14. A system for detecting an occurrence of an arc in a DC grid with one or more connectable electrical devices, wherein the system includes at least one detector unit connectable to the DC grid, the detector unit being configured to measure arc noise voltage superimposed on a DC grid voltage without a direct measurement of the current flowing through the arc itself, wherein the arc noise voltage is associated to the occurrence of an arc in the DC grid, and wherein the system is configured to ensure a minimum impedance range in a predefined frequency range for each of the electrical devices connected to the DC grid.

15. A method of determining compliance of an electrical device to be connected to a DC grid, wherein an indication of impedance for the electrical device is determined in order to check whether the electrical device meets a predetermined minimum impedance range, wherein the method includes:

superimposing a test signal on the voltage of the DC grid;
wiring an impedance measurement bridge circuit to the electrical device to be tested;
measuring a resulting amplitude voltage of the impedance measurement bridge circuit; and
comparing the resulting amplitude voltage with a reference voltage curve that corresponds to the to a minimum impedance.

FIG 1

FIG 2

FIG 3

FIG 4

FIG 5

FIG 6

FIG 7

FIG 8

FIG 9

FIG 10

Europäisches
Patentamt

European
Patent Office

Office européen
des brevets

# EUROPEAN SEARCH REPORT

**Application Number**

EP 22 18 5243

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/067291 A1 (BALOG ROBERT S [US]) 6 March 2014 (2014-03-06) | 1-3,14 | INV. G01R31/12 |
| A | * paragraph [0047] - paragraph [0067] * | 4-13 | |
| A | US 2019/372522 A1 (OKITA ATSUSHI [JP] ET AL) 5 December 2019 (2019-12-05) * paragraph [0013] - paragraph [0038] * | 1-14 | |
| A | US 2018/115144 A1 (MURNANE MARTIN [IE]) 26 April 2018 (2018-04-26) * paragraph [0029] - paragraph [0035] * | 1-14 | |
| A | WANG ZHAN ET AL: "Arc Fault and Flash Signal Analysis in DC Distribution Systems Using Wavelet Transformation", IEEE TRANSACTIONS ON SMART GRID, IEEE, USA, vol. 6, no. 4, 1 July 2015 (2015-07-01), pages 1955-1963, XP011585291, ISSN: 1949-3053, DOI: 10.1109/TSG.2015.2407868 [retrieved on 2015-06-18] * the whole document * | 1-14 | TECHNICAL FIELDS SEARCHED (IPC) G01R |

The present search report has been drawn up for all claims

| Place of search | Date of completion of the search | Examiner |
|---|---|---|
| The Hague | 1 March 2023 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

Application Number

EP 22 18 5243

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

**see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

**1-14**

☐ The present supplementary European search report has been drawn up for those parts of the European patent application which relate to the invention first mentioned in the claims (Rule 164 (1) EPC).

**LACK OF UNITY OF INVENTION
SHEET B**

Application Number

EP 22 18 5243

The Search Division considers that the present European patent application does not comply with the requirements of unity of invention and relates to several inventions or groups of inventions, namely:

    **1. claims: 1-14**

        **Method and system for detecting an occurrence of an arc in a DC grid**

        ---

    **2. claim: 15**

        **Method for determining a compliance of an electrical device to be connected to a DC grid**

        ---

## ANNEX TO THE EUROPEAN SEARCH REPORT
## ON EUROPEAN PATENT APPLICATION NO.

EP 22 18 5243

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2023

| Patent document cited in search report | | Publication date | Patent family member(s) | | Publication date |
|---|---|---|---|---|---|
| US 2014067291 | A1 | 06-03-2014 | NONE | | |
| US 2019372522 | A1 | 05-12-2019 | JP | 6741998 B2 | 19-08-2020 |
| | | | JP | 2018132382 A | 23-08-2018 |
| | | | US | 2019372522 A1 | 05-12-2019 |
| | | | WO | 2018150696 A1 | 23-08-2018 |
| US 2018115144 | A1 | 26-04-2018 | CN | 107976614 A | 01-05-2018 |
| | | | US | 2018115144 A1 | 26-04-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3599693 A1
- US 10291016 B2

- EP 1265076 A

**Non-patent literature cited in the description**

- **C. ROSE ; D. W. P. THOMAS ; C. SMARTT ; P MENG.** Proc. 2019 International Symposium on Electromagnetic Compatibility-EMC EUROPE. 02 September 2019